# EUROPÄISCHE PATENTSCHRIFT

(11) **EP 3 455 751 B1**
(45) Veröffentlichungstag und Bekanntmachung des Hinweises auf die Patenterteilung: **07.07.2021**
(21) Anmeldenummer: 17719635.9
(22) Anmeldetag: 02.05.2017
(51) Int. Cl.: G06F 30/331, G06F 30/333, G06F 30/34

(54) **VERFAHREN ZUM BESTIMMEN VON SIGNALWERTEN AUS EINEM FPGA ZUR LAUFZEIT**
METHOD FOR DETERMING SIGNAL VALUES FROM AN FPGA DURING RUNNING
PROCEDE DE DETERMINATION DES VALEURS DE SIGNAL D'UN FPGA EN COURS DE FONCTIONNEMENT

(30) Priorität: 10.05.2016 EP 16168901
(43) Veröffentlichungstag der Anmeldung: 20.03.2019
(73) Patentinhaber: dSPACE digital signal processing and control engineering GmbH, 33102 Paderborn (DE)
(72) Erfinder: KALTE, Heiko, 33106 Paderborn (DE); LUBELEY, Dominik, 33415 Verl (DE)
(86) Internationale Anmeldenummer: PCT/EP2017/060346
(87) Internationale Veröffentlichungsnummer: WO 2017/194343

(56) Entgegenhaltungen:
- EP-A1- 3 001 318
- HEMMERT K S ET AL: "Source level debugger for the sea cucumber synthesizing compiler", FIELD-PROGRAMMABLE CUSTOM COMPUTING MACHINES, 2003. FCCM 2003. 11TH AN NUAL IEEE SYMPOSIUM ON 9-11 APRIL 2003, PISCATAWAY, NJ, USA,IEEE, 9. April 2003 (2003-04-09), Seiten 228-237, XP010655292, ISBN: 978-0-7695-1979-1
- CALAGAR NAZANIN ET AL: "Source-level debugging for FPGA high-level synthesis", 2014 24TH INTERNATIONAL CONFERENCE ON FIELD PROGRAMMABLE LOGIC AND APPLICATIONS (FPL), TECHNICAL UNIVERSITY OF MUNICH (TUM), 2. September 2014 (2014-09-02), Seiten 1-8, XP032662493, DOI: 10.1109/FPL.2014.6927496

## Beschreibung

Die vorliegende Erfindung betrifft ein Verfahren zur Erstellung einer Zuordnungsliste bzw. ein Verfahren zum Bestimmen von Signalwerten aus einem FPGA zur Laufzeit, bei dem eine Zuordnungsliste genutzt wird.

Die Echtzeitsimulation von komplexen, dynamischen Modellen stellt aufgrund der engen zeitlichen Randbedingungen selbst an moderne Rechenknoten hohe Anforderungen. In automotiven Hardware-in-the-Loop-Simulationen (HiL) werden solche Modelle vor allem dort eingesetzt, wo schnelle Regelkreise geschlossen werden müssen. Dies ist etwa bei der Simulation von Zylinderinnendrucksensoren der Fall, die bei der Verbrauchs- oder Abgasreduktion eine zunehmend größere Rolle spielen. Aber auch bei Regelstrecken die eine hohe Dynamik aufweisen, wie zum Beispiel bei Elektromotoren, sind kurze Zykluszeiten und geringe Latenzen unabdingbar. Diese können mit CPU-basierten Simulationen praktisch kaum mehr umgesetzt werden.

Field Programmable Gate Arrays (FPGAs) können Rechenknoten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von FPGAs auch harte Echtzeitanforderungen leicht erfüllen. Die FPGAs können als Hardwarebeschleuniger für CPUs von Rechenknoten dienen. Entsprechend werden z.B. sehr dynamische Teile des Umgebungsmodells in das FPGA ausgelagert, so dass ausreichend präzise und schnelle Reaktionszeiten für das Steuergerät gewährleistet bleiben. Eine FPGA-Netzliste wird üblicherweise basierend auf einem FPGA Modell in einer Hardwarebeschreibungssprache in einem Build-Prozess erzeugt.
Die Modelle einer Regelstrecke werden durch steigende Anforderungen an die Genauigkeit zunehmend komplexer und somit auch schwer handhabbar. Im automotiven Hil-Umfeld werden solche Modelle in der Regel mit dem Toolset MATLAB/Simulink von The MathWorks Inc. erstellt. Simulink bietet eine blockbasierte Sicht in der Form eines Blockschaltbilds auf solche Modelle. Modellteile können in einem Blockschaltbild zu Subsystemen zusammengefasst und untereinander mit Signalen verknüpft werden. Der Datenfluss zwischen diesen Blöcken wird dabei über Signalleitungen dargestellt.

Eine FPGA-basierte Simulation kann unter Zuhilfenahme des Xilinx System Generator (XSG) und des FPGA-Programming Blocksets von dSPACE, analog zur CPU-basierten Simulation, in einem Blockschaltbild mit Simulink modelliert werden. Im Gegensatz zur CPU-Simulation wird dieses Modell allerdings nicht in eine iterative Programmiersprache übersetzt, sondern in eine FPGA-Netzliste, die eine kundenspezifische digitale Schaltung beschreibt. Die FPGA-Netzliste kann in einen FPGA-Konfigurationsdatenstrom übersetzt werden.

Die Zuordnungsliste dient dazu ein Auslesen der Signalwerte zur Laufzeit des FPGA zu ermöglichen. Aus dem Quellcode wird zunächst in eine Netzliste erzeugt, dann die Netzliste in einen Bitstrom umgewandelt und der Bitstrom auf einen FPGA geladen. Bei dieser Umwandlung wird nachverfolgt welches Register des FPGA durch welches Register des Quellcodes genutzt wird, also welches Signal des Quellcodes zur Laufzeit in welchem Register des FPGA gespeichert wird.

Aus der EP 3001318 A1 ist ein Verfahren zur automatischen Bestimmung von auslesbaren Modellsignalen eines FPGA-Programms bekannt.

Wenn der Wert eines bestimmten Signals aus dem FPGA ausgelesen werden soll, kann mit der Zuordnungsliste bestimmt werden, welches Register des FPGA ausgelesen werden muss. Dieser Auslesevorgang kann über verschiedene Techniken realisiert werden. Beispielsweise kann das Register über eine Readbackschnittstelle ausgelesen werden, dies ist in der EP2765528A1 beschrieben. Dabei können sowohl die Register ausgelesen werden, die von der im FPGA-Quellcode beschriebenen Funktion genutzt werden, als auch Register, die nur für die Speicherung der Signalwerte zum Auslesen dienen und für die im FPGA-Quellcode beschriebene Funktion nicht von Bedeutung sind. Alternativ können die Register über einen Adressdecoder gezielt ausgelesen werden. Alternativ können die Register zu einer Schieberegisterkette verbunden und nacheinander ausgelesen werden.

Aufgabe der Erfindung ist es, den Stand der Technik weiterzubilden.

Die Erfindung betrifft ein Verfahren zum Bestimmen von Signalwerten aus einem FPGA zur Laufzeit, bei dem eine Zuordnungsliste genutzt wird. Die Zuordnungsliste für die Bestimmung der Signalwerte wird basierend auf einem FPGA-Quellcode erstellt,
wobei der Quellcode mindestens ein erstes Signal an einer ersten Stelle verwendet,
wobei dem ersten Signal mindestens ein erstes Register zugeordnet ist, wobei in der Zuordnungsliste das erste Signal und das erste Register als einander zugeordnet aufgeführt werden,
wobei ein zweites Signal an einer zweiten Stelle im FPGA-Quellcode verwendet wird,
wobei automatisiert erkannt wird, dass der Wert des zweiten Signals nach einer ersten Berechnungsvorschrift aus dem Wert des ersten Signals bestimmt werden kann,
wobei in der Zuordnungsliste das zweite Signal, das erste Register und die erste Berechnungsvorschrift als einander zugeordnet aufgeführt werden.

Ein erster Wert eines ersten Signals wird zur Laufzeit aus einem ersten Register ausgelesen,
wobei in der Zuordnungsliste das erstes Signal, das erste Register, ein zweites Signal und eine erste Berechnungsvorschrift als einander zugeordnet aufgeführt werden,
wobei ein zweiter Wert des zweiten Signals aus dem ersten Wert über die erste Berechnungsvorschrift bestimmt wird.

Vorteilhaft an dem Verfahren ist, dass der Wert des zweiten Signals nicht ausgelesen werden muss. Zusätzlich können Werte bestimmt werden, die nicht in einem Register gespeichert sind.

Eine nach dem erfindungsgemäßen Verfahren erstellte Zuordnungsliste ist vorteilhaft beim Auslesen von Signalwerten zur Laufzeit. Zur Laufzeit wird der Wert des ersten Signals im ersten Register gespeichert. Zur Laufzeit kann der Signalwert wie oben beschrieben auf verschiedene Arten ausgelesen werden. Durch die Berechnungsvorschrift ist es nicht notwendig, dass ein Register ausgelesen wird, das dem zweiten Signal zugeordnet ist. Wenn der erste Signalwert und der zweite Signalwert ausgelesen werden sollen, muss nur das erste Register ausgelesen werden, was eine zeitliche Einsparung mit sich bringt.

Durch die erfindungsgemäße Zuordnungsliste ist es nicht notwendig, dass dem zweiten Signal ein Register zugeordnet ist. Wenn der Wert des zweiten Signals ausgelesen werden soll, wird das erste Register, das dem ersten Signal zugeordnet ist, ausgelesen und der Wert des zweiten Signals entsprechend der Berechnungsvorschrift aus dem ausgelesenen Wert des ersten Registers bestimmt. Da das zweite Signal nicht in einem Register gespeichert werden muss, kann ein Register eingespart werden. Es werden Signalwerte bestimmbar, die zur Laufzeit im FPGA nicht in einem Register gespeichert werden.

Die Zuordnungsliste enthält die Zuordnungen von Signalen, Registern und Berechnungsvorschriften. Jedes Objekt der Liste enthält folglich mindestens drei Elemente. Die Zuordnungsliste kann folglich auch als Zuordnungstabelle aufgefasst werden. Bspw. kann in jeder Zeile eine Zuordnung stehen. In der ersten Spalte das jeweilige Signal, in der zweiten Spalte das zugeordnete Register und in der dritten Spalte die Berechnungsvorschrift mit der das Signal aus dem Registerwert berechnet wird.

In einer alternativen Ausgestaltung besteht das zweite Signal aus einer Untermenge der Bits des ersten Signals und die Zuordnungsvorschrift definiert die Bits des ersten Signals, welche den Wert des zweiten Signals beschreiben. In diesem Fall werden bei der Bestimmung des Wertes des zweiten Signals nur diejenigen Bits verwendet, die durch die Zuordnungsvorschrift definiert werden. Die anderen Bits werden verworfen. Falls der erste Signalwert nicht benötigt wird, kann auf das Auslesen der nicht benötigten Bits verzichtet werden.

In einer alternativen Ausgestaltung ist das zweite Signal nur durch eine oder mehrere biterhaltende Rechenoperationen mit dem ersten Signal verbunden. Unter einer biterhaltenden Rechenoperation wird verstanden, dass sich die Werte einer Folge von Bits nicht ändern, die Bitfolge wird also lediglich verschoben, dies wird auch als Shifting bezeichnet, oder anders interpretiert, dies wird auch als Casting bezeichnet.

In einer alternativen Ausgestaltung ist das zweite Signal durch eine oder mehrere bitverändernde Rechenoperationen mit dem ersten Signal verbunden. Zur Bestimmung des zweiten Signalwertes wird der Wert des ersten Signals ausgelesen und die bitverändernde Rechenoperation nachvollzogen.

In einer bevorzugten Ausführungsform gibt die bitverändernde Rechenoperation das Rechenergebnis im gleichen Takt aus. Um den Signalwert des zweiten Signals zu bestimmen, muss nach dem Auslesen des ersten Signalwertes aus dem Register des FPGA die Rechenoperationen nachvollzogen werden. Wenn das Ergebnis der Rechenoperation im gleichen Takt vorliegt, sind durch das Nachvollziehen der Rechenoperation der erste Signalwert und der zweite Signalwert im gleichen Takt bekannt. Dies ist vorteilhaft, da häufig ein konsistentes Bild vieler Variablen erstellt werden soll, um den Zustand des FPGA zu bestimmen.

In einer Ausgestaltung ist die bitverändernde Rechenoperation eine kombinatorische Logikoperation. Kombinatorische Logikoperationen, die keine Taktverzögerung besitzen, wo also die Ergebnisse im selben Takt vorliegen sind beispielsweise:
- Logikoperationen (NOT, AND, NAND, OR, NOR, XOR)
- LookUp-Table Operationen
- Elementare Rechenoperationen ohne Pipeline Stufen (SUM, SUBTRACT, ...) Analog zum Vorgehen bei biterhaltenden Rechenoperationen, können die Ergebnisse dieser bitverändernden Rechenoperationen ebenfalls durch Referenzen auf die Eingangsvariablen ermittelt werden.

In einer Ausgestaltung verrechnet die bitverändernde Rechenoperation das erste Signal mit einem dritten Signal, wobei dem dritten Signal ein drittes Register zugeordnet ist, wobei in der Zuordnungsliste dem ersten Signal zusätzlich das dritte Register zugeordnet wird, wobei die erste Berechnungsvorschrift angibt wie der Wert des zweiten Signals aus dem Wert des ersten Signals und dem Wert des dritten Signals berechnet werden kann.

Allgemein kann bei einer Rechenoperation mit einer Vielzahl von Eingängen, wenn jedes Eingangssignal in einem Register gespeichert wird, das bzw. die Ausgangssignale aus den Werten der Eingangssignale bestimmt werden können. Die Ausgangssignale müssen also nicht ausgelesen werden. Eine Rechenoperation kann auch aus einer Vielzahl kleinerer Rechenoperationen zusammengesetzt sein. Bspw. kann eine Addition zweier Signalwerte mit anschließender Multiplikation der Summe mit einem dritten Wert als eine Rechenoperation mit drei Eingangssignalen und einem Ausgangssignal aufgefasst werden.

Das dritte Register dient dazu zur Laufzeit den Wert des dritten Signals zu speichern. Zur Laufzeit kann dann der Wert des ersten Signals aus dem ersten Register und der Wert des dritten Signals aus dem dritten Register ausgelesen werden. Durch nachrechnen der bitverändernden Rechenoperation kann dann der Wert des zweiten Signals bestimmt werden, ohne dass der Wert des zweiten Signals ausgelesen werden muss.

In einer weiteren Ausgestaltung ist dem zweiten Signal im FPGA-Quellcode ein zweites Register zugeordnet, wobei in der Zuordnungsliste das zweite Register zusätzlich zum ersten Register und der Berechnungsvorschrift als dem zweiten Signal zugeordnet aufgeführt wird.

Durch das zweite Register steht eine alternative Bestimmungsmethode des zweiten Signalwertes zur Verfügung. Der zweite Signalwert kann dann anhand der Zuordnungsliste entweder durch das Auslesen des ersten Registers und die Berechnungsvorschrift bestimmt werden oder über das Auslesen des zweiten Registers. Durch den Vergleich der beiden Ergebnisse der beiden Bestimmungsmethoden können Hinweise auf Fehler gefunden werden. Fehler die dadurch auffallen können sind bspw.:
- Fehler der CPU beim Nachrechnen des zweiten Signalwertes aus dem Wert des ersten Signals.
- Rechenfehler im FPGA, wodurch die Berechnung des zweiten Wertes fehlerhaft ist.
- Fehler in der Implementierung des Quellcodes auf dem FPGA.
Durch das zweite Register entfällt also der oben beschriebene Vorteil, dass ein Register eingespart werden kann, dafür ist durch die Zuordnungsvorschrift die Möglichkeit der Fehlererkennung geschaffen.

In einer weiteren Ausgestaltung werden die Dauer des Auslesens des zweiten Registers und die Dauer des Berechnens des zweiten Signalwertes aus dem ersten Signalwert abgeschätzt und basierend auf den Abschätzungen die schnellere Methode als die bevorzugte Methode in der Zuordnungsliste angegeben.

Vorteilhaft ist, dass zur Laufzeit sehr schnell entschieden werden kann, welche Methode angewandt werden soll.

Sind die Register für ein Auslesen über eine Schieberegisterkette oder einen Adressdecoder eingerichtet, so lässt sich die für das Auslesen benötigte Zeitdauer aus den Eigenschaften des Auslesemechanismus bestimmen. Sind die Register für ein Auslesen über eine Readbackschnittstelle eingerichtet, so ist eine gute Abschätzung der Auslesedauer erst nach der Erstellung der Netzliste möglich, wenn die Bitpositionen der Werte im Bitstrom bekannt sind.

Die Dauer der Berechnung des zweiten Signalwertes aus dem ersten Signalwert, lässt sich bei bekanntem Prozessor aus den benötigten Prozessorbefehlen und ihren Ausführungsdauern abschätzen. Alternativ kann die Berechnungsdauer empirisch auf dem Zielprozessor oder einem vergleichbaren Prozessor bestimmt werden.

Erfindungsgemäß wird der FPGA-Quellcode auf einem FPGA implementiert, wobei zur Laufzeit das erste Register aus dem FPGA ausgelesen wird, wobei mittels der Berechnungsvorschrift aus der Zuordnungsliste der zweite Signalwert bestimmt wird.

Zur Laufzeit wird der Wert des ersten Signals im ersten Register gespeichert. Zur Laufzeit wird der Signalwert ausgelesen. Mögliche Techniken zum Auslesen des Registers sind oben angegeben. Durch die Berechnungsvorschrift ist es nicht notwendig, dass ein Register ausgelesen wird, das dem zweiten Signal zugeordnet ist. Es wird nur das erste Register ausgelesen und der zweite Wert mittels der Berechnungsvorschrift bestimmt, was eine zeitliche Einsparung mit sich bringt. Da das zweite Signal nicht in einem Register gespeichert werden muss, kann ein Register eingespart werden.

In einer weiteren Ausgestaltung ist dem zweiten Signal im FPGA-Quellcode ein zweites Register zugeordnet, wobei in der Zuordnungsliste das zweite Register zusätzlich zum ersten Register und der Berechnungsvorschrift als dem zweiten Signal zugeordnet aufgeführt wird, wobei zur Laufzeit automatisiert entschieden wird, ob der zweite Signalwert aus dem zweiten Register ausgelesen wird oder der zweite Signalwert aus dem ersten Signalwert über die Berechnungsvorschrift bestimmt wird.

Vorteilhaft ist, dass bei der Bestimmung des zweiten Signalwertes auf die Laufzeitbedingungen Rücksicht genommen werden kann. Wenn auch der erste Signalwert bestimmt werden soll, wird es im Allgemeinen schneller sein den zweiten Signalwert aus dem ersten Signalwert zu berechnen, als den zweiten Signalwert aus dem zweiten Register auszulesen. Wenn der erste Signalwert nicht bestimmt werden soll, wird es im Allgemeinen schneller sein, den zweiten Signalwert aus dem zweiten Register auszulesen, als den ersten Signalwert aus dem ersten Register auszulesen und daraus den zweiten Signalwert zu berechnen.

In manchen Entwicklungsumgebungen lassen sich mehrere Signale zusammenfassen zu einem Bus. Bei solchen zusammengefassten Signalen wird für jedes Signal eines Busses einzeln bestimmt, ob der Signalwert aus anderen Registerwerten mittels einer Berechnungsvorschrift bestimmt werden kann. Entsprechend wird jedes Signal einzeln in der Zuordnungsliste behandelt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben auch keine ableitbaren geometrischen Relationen zueinander auf. Darin zeigt:
Figur 1 Die Referenzierung von Register am Beispiel von identischen Signalen
Figur 2 Die Referenzierung von Registern am Beispiel einer Bitreduktion
Figur 3 Die Referenzierung von Registern am Beispiel einer biterhaltenden Rechenoperation
Figur 4 Die Referenzierung von Registern am Beispiel einer bitverändernden Rechenoperation
Figur 5 Die mehrfache Referenzierung von Registern am Beispiel einer bitverändernden Rechenoperation

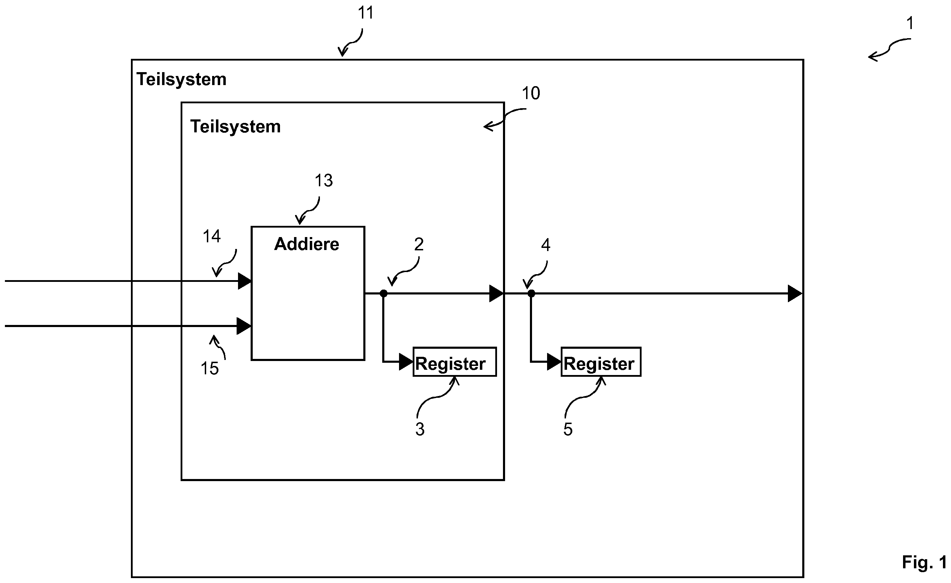

Figur 1 zeigt einen grafischen FPGA-Quellcode 1 bestehend aus zwei in einander verschachtelten Subsystemen 10, 11. Das erste Subsystem 10 enthält einen ersten Logikblock 13 und einen zweiten Logikblock 14. Der erste Logikblock 13 hat zwei Eingangssignale 14, 15 und ein erstes Ausgangssignal 2. Dem ersten Ausgangssignal 2 ist ein erstes Register 3 zugeordnet. Das erste Register 3 dient dazu zur Laufzeit den Wert des ersten Ausgangssignals 2 zu speichern und ein Auslesen des Wertes zur Laufzeit zu ermöglichen.

Das erste Subsystem 10 ist in ein zweites Subsystem 11 eingebettet. Das erste Ausgangssignal 4 des ersten Subsystems 10 ist identisch mit dem ersten Ausgangssignal 2 des ersten Logikblocks 13 innerhalb des ersten Subsystems 10. Bei der Erstellung der Zuordnungsliste wird dies erkannt und dem ersten Ausgangssignal 4 des ersten Subsystems das erste Register 3 innerhalb des ersten Subsystems 10 zugeordnet. Als Zuordnungsvorschrift zwischen dem ersten Ausgangssignal 4 des ersten Subsystems 10 und dem ersten Register 2 wird in der Zuordnungsliste die Identität angegeben. Das zweite Register 5, das dem ersten Ausgangssignal 4 des ersten Subsystems 10 zugeordnet ist, kann daher bei der Implementierung eingespart werden. Dadurch werden Ressourcen im FPGA gespart. Alternativ kann das zweite Register 5 im FPGA implementiert werden, dann kann der Wert des ersten Ausgangssignals 4 des ersten Subsystems 10 aus dem zweiten Register 5 ausgelesen werden, was eine Möglichkeit schafft Fehler zur Laufzeit zu erkennen.

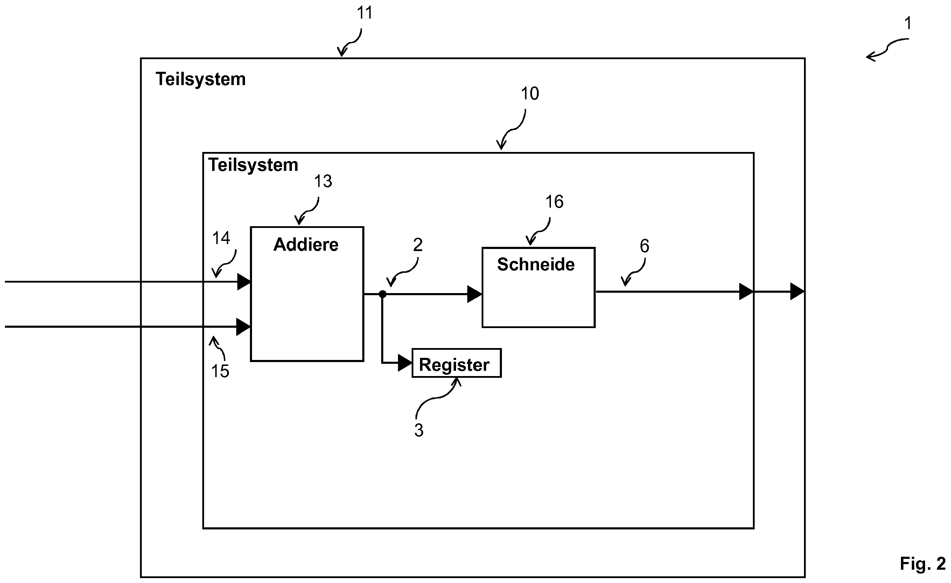

Figur 2 zeigt einen weiteren grafischen FPGA-Quellcode 1. Im Folgenden werden nur die Unterschiede zu Figur 1 beschrieben. Das erste Signal 2 wird in diesem Ausführungsbeispiel durch einen sogenannten Slice-Block 16 zu einem zweiten Signal 6 weiterverarbeitet. Mit einem Slice-Block 16 können nicht benötigte Bits eines Signals verworfen werden. Beispielsweise kann das erste Signal 2 zwanzig Bit groß sein, das zweite Signal 6 hingegen nur zwölf Bit, da nur diese zwölf Bit benötigt werden. Das zweite Signal 6 könnte ebenso wie das zweite Signal 2 aus Figur 1 in einem Register gespeichert werden, dies ist in Figur 2 nicht dargestellt.

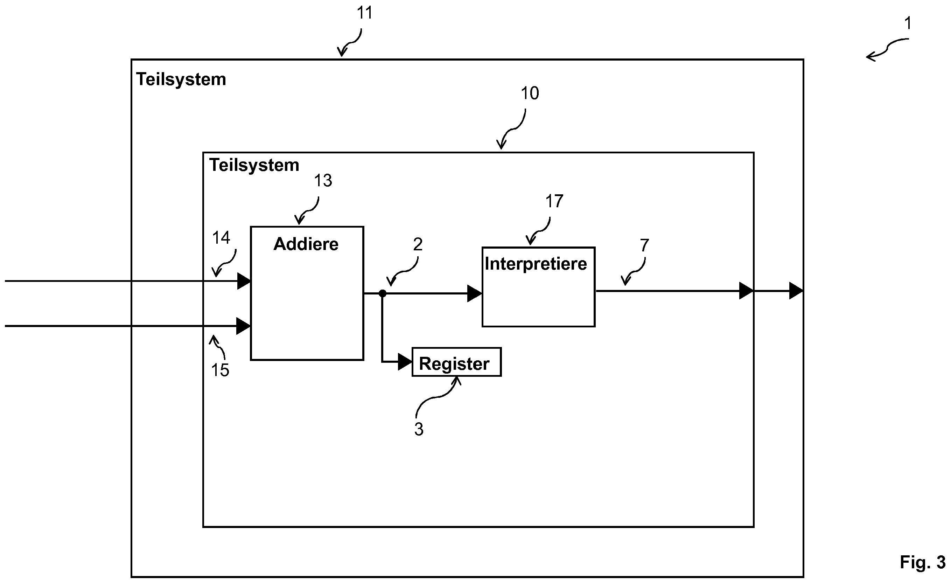

Figur 3 zeigt einen weiteren grafischen FPGA-Quellcode 1. Im Folgenden werden nur die Unterschiede zu Figur 2 beschrieben. Das erste Signal 2 wird in diesem Ausführungsbeispiel durch einen sogenannten reinterpret-Block 17 zu einem zweiten Wert 7 weiterverarbeitet. Ein reinterpret-Block 17 lässt die Bitfolge des Signals unverändert, beeinflusst jedoch die logische Interpretation des Signals im Programm. Beispielsweise kann das erste Signal 2 eine fünfunddreißig Bit Ganzzahl darstellen, das zweite Signal 7 hingegen eine Fließkommazahl mit fünfzehn Bit Mantissse und zehn Bit Exponent. Das zweite Signal 7 könnte ebenso wie das zweite Signal 2 aus Figur 1 in einem Register gespeichert werden, dies ist in Figur 3 nicht dargestellt.

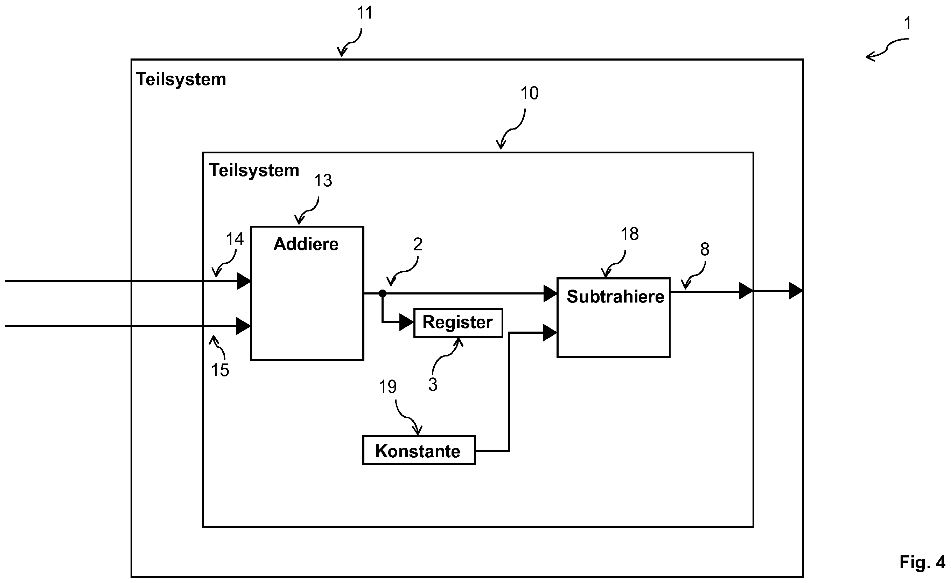

Figur 4 zeigt einen weiteren grafischen FPGA-Quellcode 1. Im Folgenden werden nur die Unterschiede zu Figur 2 beschrieben. Das erste Signal 2 wird in diesem Ausführungsbeispiel durch einen sogenannten Subtract-Block 18 zu einem zweiten Wert 8 weiterverarbeitet. Der Subtract-Block 18 subtrahiert von dem ersten Signal 2 eine Konstante 19.

Der Wert der Konstanten 19 muss nicht wie der erste Wert des ersten Signals 2 zur Bestimmung des Wertes des zweiten Signals 8 ausgelesen werden. Der Wert der Konstanten 19 kann in der Zuordnungsliste oder einer anderen Weise fest abgelegt werden, sodass auf den Wert der Konstanten 19 bei der Berechnung des Wertes des zweiten Signals 8 zugegriffen werden kann. Alternativ kann der Wert der Konstanten 19 einmalig vom FPGA ausgelesen werden, um Fehler im FPGA Buildtool oder der Hardware auszuschließen. Alternativ oder zusätzlich kann der Wert der Konstanten 19 in vordefinierten Abständen vom FPGA ausgelesen werden, um Fehler durch Umgebungsbedingungen oder Hardwarefehler auszuschließen.

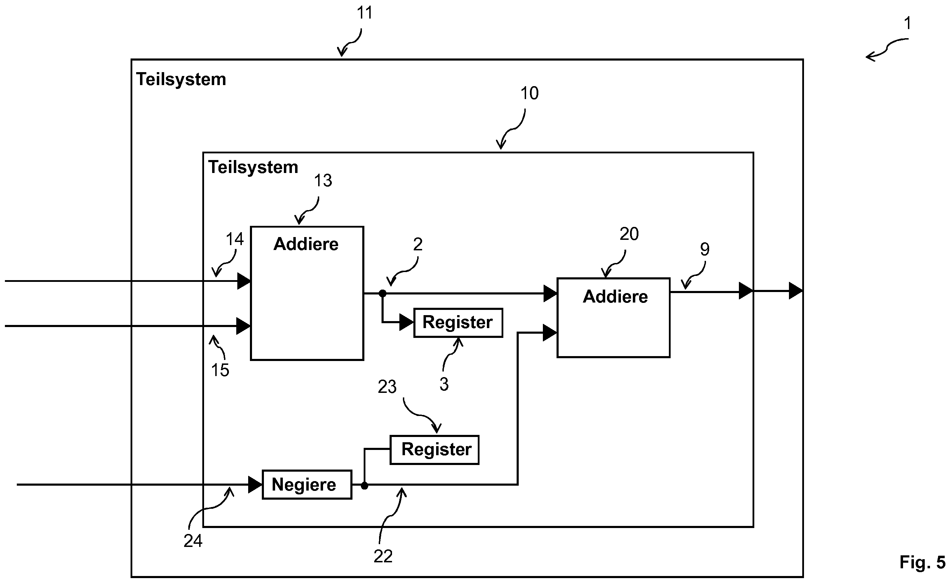

Figur 5 zeigt einen weiteren grafischen FPGA-Quellcode 1. Im Folgenden werden nur die Unterschiede zu Figur 4 beschrieben. Das erste Signal 2 wird in diesem Ausführungsbeispiel durch einen sogenannten Additions-Block 20 zu einem zweiten Wert 9 weiterverarbeitet. Der Additions-Block 20 addiert auf das erste Signal 2 ein drittes Signal 22. Dem dritten Signal 23 ist ein drittes Register 23 zugeordnet. Das dritte Register 23 ist dazu eingerichtet zur Laufzeit den Wert des dritten Signals 23 zu speichern. Zur Laufzeit werden der Wert des ersten Signals 2 aus dem ersten Register 3 und der Wert des dritten Signals 22 aus dem dritten Register 23 ausgelesen. Der Wert des zweiten Signals 9 kann dann durch Addition der ausgelesenen Werte bestimmt werden.

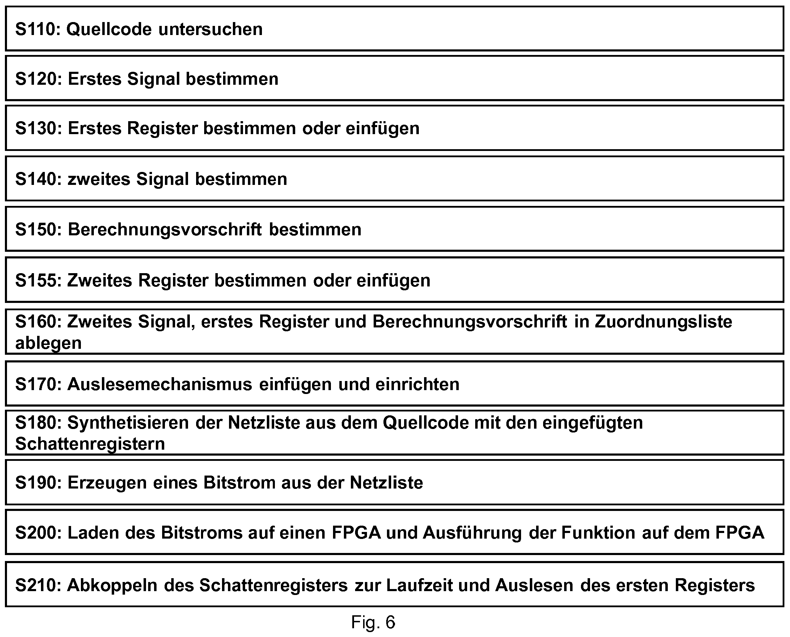

Figur 6 zeigt die Schritte eines erfindungsmäßen Verfahrens. Einige Schritte sind dabei obligatorisch, andere Schritte sind optional. In einem ersten obligatorischen Schritt S110 wird der Quellcode 1 untersucht. Dabei werden die im Quellcode 1 definierten Signale bestimmt. In einem zweiten obligatorischen Schritt S120 wird ein erstes Signal 2 im Quellcode 1 bestimmt. In einem dritten obligatorischen Schritt S130 wird bestimmt in welchem Register 3 das im zweiten Schritt S120 bestimmte erste Signal 2 zur Laufzeit gespeichert wird. Falls dem ersten Signal 2 kein erstes Register 3 zugeordnet ist, wird ein erstes Register 3 in den Quellcode eingefügt. Zusätzlich kann für das erste Register 3 ein Abkoppelmechanismus in den Quellcode eingefügt und eingerichtet oder das Schattenregister 10 mit einem bereits eingefügten Abkoppelmechanismus verbunden werden. Ein Abkoppelmechanismus kann bspw. die Taktleitung des Registers oder das enable-Signal des Registers unterbrechen. Der Abkoppelmechanismus ist in der Lage, das Register zur Laufzeit zeitweise vom zugeordneten Signal zu trennen, sodass der im Register gespeicherte Wert während der Trennung nicht aktualisiert wird. Vorteilhafterweise werden eine Vielzahl von Registern mit demselben Abkoppelmechanismus verbunden. Dadurch können die Register gleichzeitig abgekoppelt werden und ein konsistenter Satz von Signalwerten in den Registern gespeichert werden. Dies ist insbesondere vorteilhaft, wenn ein zweites Signal aus den Werten von mehreren Signalen berechnet werden soll. In einem vierten obligatorischen Schritt S140 wird ein zweites Signal 4, 6, 7, 8, 9 bestimmt, In einem fünften obligatorischen Schritt S150 wird die Berechnungsvorschrift erstellt mit der der Wert des im vierten Schritt S140 bestimmten zweiten Signals 4, 6, 7, 8, 9 aus dem Wert des im zweiten Schritt S120 bestimmten ersten Signals 2 bestimmt werden kann. Die Berechnungsvorschrift ist im Allgemeinen eine Übernahme der im Quellcode 1 zwischen dem ersten Signal 2 und dem zweiten Signal 4, 6, 7, 8, 9 definierten Berechnungen. In einem sechsten optionalen Schritt S155 wird bestimmt in welchem Register 5 das zweite Signal 4, 6, 7, 8, 9 gespeichert wird. Falls ein solches zweites Register 5 bestimmt werden kann, wird es im siebten Schritt 160 verwendet. Falls kein solches zweites Register 5 bestimmt werden kann, wird ein zweites Register 5 analog zum ersten Register 3 aus dem dritten Schritt S130 eingefügt.

In einem optionalen siebenten Schritt S160 wird für das im dritten Schritt S130 bestimmte erste Register 3 und/oder für das im sechsten Schritt S155 bestimmte zweite Register ein Auslesemechanismus in den Quellcode eingefügt.

In einem optionalen achten Schritt S170 wird ein Auslesemechanismus für das erste Register 3 in den Quellcode eingefügt und eingerichtet. Das Einfügen und Einrichten des Auslesemechanismus kann z.B. darin bestehen, dass in den Quellcode eine Anweisung an die Implementierungswerkzeuge eingefügt wird, dass auf dem FPGA, auf den die Netzliste geladen werden soll, das Auslesen über eine Readbackschnittstelle ermöglicht werden soll. Falls ein Auslesen des ersten Registers 3 ohne einen solchen Mechanismus möglich ist, so ist das Einfügen eines Auslesemechanismus nicht notwendig. Es kann auch vorgesehen sein, dass ein Auslesemechanismus erst später im Verfahren in das aus dem Quellcode erstellte FPGA-Programm eingefügt wird.

Der zweite bis achte Schritt können mehrfach wiederholt werden, um einer Vielzahl von Signalen Register und Berechnungsvorschriften zuzuordnen. Bevorzugt werden der zweite bis achte Schritt automatisiert durch einen Algorithmus wiederholt abgearbeitet, wobei der Algorithmus systematisch alle im Quellcode definierten Signale abarbeitet.

In einem optionalen neunten Schritt S180 wird aus dem Quellcode eine Netzliste synthetisiert. In einem optionalen zehnten Schritt S190 wird die im neunten Schritt S180 erzeugte Netzliste in einen Bitstrom umgewandelt, der dann in einem optionalen elften Schritt S200 auf einen FPGA geladen und dort zur Ausführung gebracht werden kann. Zur Laufzeit des FPGA kann dann in einem optionalen zwölften Schritt S210 das im dritten Schritt S130 bestimmte erste Register 3 ausgelesen werden. Der Wert des zweiten Signals 4, 6, 7, 8, 9 kann dann aus dem ausgelesenen Wert über die Berechnungsvorschrift ermittelt werden.

## Patentansprüche

1. Verfahren zum Bestimmen von Signalwerten aus einem FPGA zur Laufzeit,
wobei eine Zuordnungsliste basierend auf einem FPGA-Quellcode (1) erstellt wird,
wobei der FPGA-Quellcode (1) mindestens ein erstes Signal (2) an einer ersten Stelle verwendet, wobei dem ersten Signal (2) mindestens ein erstes Register (3) zugeordnet ist,
wobei in der Zuordnungsliste das erste Signal (2) und das erste Register (3) als einander zugeordnet aufgeführt werden,
wobei ein zweites Signal (4, 6, 7, 8, 9) an einer zweiten Stelle im FPGA-Quellcode (1) verwendet wird,
wobei der FPGA-Quellcode auf einem FPGA implementiert wird, wobei die erstellte Zuordnungsliste beim Auslesen von Signalwerten zur Laufzeit genutzt wird,
wobei ein erster Wert des ersten Signals (2) zur Laufzeit aus dem ersten Register (3) ausgelesen wird,
**dadurch gekennzeichnet, dass**
bei der Erstellung der Zuordnungsliste automatisiert erkannt wird, dass der Wert des zweiten Signals (4, 6, 7,8 ,9) nach einer ersten Berechnungsvorschrift aus dem Wert des ersten Signals (2) bestimmt werden kann,
wobei das zweite Signal (7) durch eine oder mehrere biterhaltende Rechenoperationen (7) oder durch eine oder mehrere bitverändernde Rechenoperationen (18, 19) mit dem ersten Signal (2) verbunden ist, wobei in der Zuordnungsliste das zweite Signal (4), das erste Register (3) und die erste Berechnungsvorschrift als einander zugeordnet aufgeführt werden, und
wobei beim Auslesen ein zweiter Wert des zweiten Signals (4) aus dem ersten Wert über die erste Berechnungsvorschrift bestimmt wird.

2. Verfahren nach Anspruch 1, **dadurch gekennzeichnet, dass** die bitverändernde Rechenoperation (18, 19) das Rechenergebnis im gleichen Takt ausgibt.

3. Verfahren nach Anspruch 1 oder 2, **dadurch gekennzeichnet, dass** die bitverändernde Rechenoperation (18, 19) eine kombinatorische Logikoperation ist.

4. Verfahren nach einem der vorhergehenden Ansprüche, **dadurch gekennzeichnet, dass**
die bitverändernde Rechenoperation (19) das erste Signal (2) mit einem dritten Signal (22) verrechnet, wobei dem dritten Signal (22) ein drittes Register (23) zugeordnet ist, wobei in der Zuordnungsliste dem ersten Signal (2) zusätzlich das dritte Register (23) zugeordnet wird, wobei die erste Berechnungsvorschrift angibt wie der Wert des zweiten Signals (9) aus dem Wert des ersten Signals (2) und dem Wert des dritten Signals (22) berechnet werden kann.

5. Verfahren nach einem der vorhergehenden Ansprüche, **dadurch gekennzeichnet, dass**
dem zweiten Signal (4, 6, 7, 8, 9) im FPGA-Quellcode ein zweites Register (5) zugeordnet ist,
wobei in der Zuordnungsliste das zweite Register (5) zusätzlich zum ersten Register (3) und der Berechnungsvorschrift als dem zweiten Signal (4, 6, 7, 8, 9) zugeordnet aufgeführt wird.

6. Verfahren nach Anspruch 5, **dadurch gekennzeichnet, dass** die Dauer des Auslesens des zweiten Registers (5) und die Dauer des Berechnens des zweiten Signalwertes (4, 6, 7, 8, 9) aus dem ersten Signalwert (2) abgeschätzt werden und basierend auf den Abschätzungen die schnellere Methode als die bevorzugte Methode in der Zuordnungsliste angegeben wird.

7. Verfahren nach einem der vorhergehenden Ansprüche, **dadurch gekennzeichnet, dass** dem zweiten Signal (4, 6, 7, 8, 9) im FPGA-Quellcode ein zweites Register (5) zugeordnet ist, wobei in der Zuordnungsliste das zweite Register (5) zusätzlich zum ersten Register (3) und der Berechnungsvorschrift als dem zweiten Signal (4, 6, 7, 8, 9) zugeordnet aufgeführt wird, wobei zur Laufzeit automatisiert entschieden wird, ob der zweite Signalwert (4, 6, 7, 8, 9) aus dem zweiten Register (5) ausgelesen wird oder der zweite Signalwert (4, 6, 7, 8, 9) aus dem ersten Signalwert (2) über die Berechnungsvorschrift bestimmt wird.

## Claims

1. A method for determining signal values from an FPGA at runtime,
an association list being created based on an FPGA source code (1),
the FPGA source code (1) using at least one first signal (2) at a first location, at least one first register (3) being associated with the first signal (2),
the first signal (2) and the first register (3) being listed as associated with each other in the association list, a second signal (4, 6, 7, 8, 9) being used at a second location in the FPGA source code (1),
the FPGA source code being implemented on an FPGA, the created association list being used at runtime when reading out signal values,
a first value of the first signal (2) being read out from the first register (3) at runtime,
**characterized in that**
when creating the association list, it is automatically detected that the value of the second signal (4, 6, 7, 8, 9) can be determined from the value of the first signal (2) according to a first calculation specification,
wherein the second signal (7) is connected to the first signal (2) by one or more bit-retaining calculation operations (7) or by one or more bit-modifying calculation operations (18, 19), wherein the second signal (4), the first register (3), and the first calculation specification are listed as associated with each other in the association list, and
wherein a second value of the second signal (4) is determined from the first value by means of the first calculation specification when reading out.

2. The method according to claim 1, **characterized in that** the bit-modifying calculation operation (18, 19) outputs the calculation results in the same cycle.

3. The method according to claim 1 or 2, **characterized in that** the bit-modifying calculation operation (18, 19) is a combinatory logic operation.

4. The method according to any one of the preceding claims,
**characterized in that**
the bit-modifying calculation operation (19) offsets the first signal (2) by means of a third signal (22), wherein a third register (23) is associated with the third signal (22), wherein the third register (23) is additionally associated with the first signal (2) in the association list, wherein the first calculation specification indicates how the value of the second signal (9) can be calculated from the value of the first signal (2) and the value of the third signal (22).

5. The method according to any one of the preceding claims,
**characterized in that**
a second register (5) is associated with the second signal (4, 6, 7, 8, 9) in the FPGA source code,
wherein the second register (5), in addition to the first register (3) and the calculation specification, is listed as associated with the second signal (4, 6, 7, 8, 9) in the association list.

6. The method according to claim 5, **characterized in that** the duration of reading out the second register (5) and the duration of calculating the second signal value (4, 6, 7, 8, 9) are estimated from the first signal value (2) and, based on the estimation, the faster method is indicated in the association list as the preferred method.

7. The method according to any one of the preceding claims, **characterized in that** a second register (5) is associated with the second signal (4, 6, 7, 8, 9) in the FPGA source code, wherein the second register (5), in addition to the first register (3) and the calculation specification, is listed as associated with the second signal (4, 6, 7, 8, 9) in the association list, wherein it is automatically decided at runtime whether the second signal value (4, 6, 7, 8, 9) is read out from the second register (5) or the second signal value (4, 6, 7, 8, 9) is determined from the first signal value (2) by means of the calculation specification.

## Revendications

1. Procédé pour déterminer des valeurs de signaux provenant d'un FPGA pendant la durée d'exécution,
dans lequel une liste d'assignation est générée sur la base d'un code source FPGA (1),
dans lequel le code source FPGA (1) utilise au moins un premier signal (2) à un premier emplacement, dans lequel au moins un premier registre (3) est attribué au premier signal (2),
dans lequel dans la liste d'assignation, le premier signal (2) et le premier registre (3) sont listés comme étant assignés l'un à l'autre, dans lequel un deuxième signal (4, 6, 7, 8, 9) est utilisé à un deuxième emplacement dans le code source FPGA (1),
dans lequel le code source FPGA est mis en œuvre sur un FPGA, dans lequel la liste d'assignation générée est utilisée lors de la lecture de valeurs de signaux sur la durée d'exécution,
dans lequel une première valeur du premier signal (2) sur la durée d'exécution est lue à partir du premier registre (3),
**caractérisé en ce que**
lors de la génération de la liste d'assignation, il est automatiquement reconnu que la valeur du deuxième signal (4, 6, 7, 8, 9) peut être déterminée à partir de la valeur du premier signal (2) selon une première règle de calcul,
dans lequel le deuxième signal (7) est relié au premier signal (2) par une ou plusieurs opérations de calcul (7) à conservation de bits ou par une ou plusieurs opérations de calcul (18, 19) à modification de bits, dans lequel, dans la liste d'assignation, le deuxième signal (4), le premier registre (3) et la première règle de calcul sont listés comme étant assignés les uns aux autres, et
dans lequel, lors de la lecture, une deuxième valeur du deuxième signal (4) est déterminée à partir de la première valeur à l'aide de la première règle de calcul.

2. Procédé selon la revendication 1, **caractérisé en ce que** l'opération de calcul (18, 19) à modification de bit sort le résultat du calcul dans le même rythme.

3. Procédé selon la revendication 1 ou 2, **caractérisé en ce que** l'opération de calcul (18, 19) à modification de bit est une opération de logique combinatoire.

4. Procédé selon l'une quelconque des revendications précédentes, **caractérisé en ce que**
l'opération de calcul (19) à modification de bit compense le premier signal (2) avec un troisième signal (22), dans lequel un troisième registre (23) est assigné au troisième signal (22), dans lequel, dans la liste d'assignation, le troisième registre (23) est additionnellement assigné au premier signal (2), dans lequel la première règle de calcul spécifie comment la valeur du deuxième signal (9) peut être calculée à partir de la valeur du premier signal (2) et de la valeur du troisième signal (22).

5. Procédé selon l'une quelconque des revendications précédentes, **caractérisé en ce que**
un deuxième registre (5) est assigné au deuxième signal (4, 6, 7, 8, 9) dans le code source FPGA,
dans lequel, dans la liste d'assignation, le deuxième registre (5) est listé comme étant affecté au deuxième signal (4, 6, 7, 8, 9) en plus du premier registre (3) et de la règle de calcul.

6. Procédé selon la revendication 5, **caractérisé en ce que** la durée de lecture du deuxième registre (5) et la durée de calcul de la deuxième valeur de signal (4, 6, 7, 8, 9) à partir de la première valeur de signal (2) sont estimées et, sur la base des estimations, le procédé le plus rapide est indiqué comme le procédé préféré dans la liste d'assignation.

7. Procédé selon l'une quelconque des revendications précédentes, **caractérisé en ce qu'**un deuxième registre (5) est assigné au deuxième signal (4, 6, 7, 8, 9) dans le code source FPGA, dans lequel, dans la liste d'assignation, le deuxième registre (5) est listé comme étant affecté au deuxième signal (4, 6, 7, 8, 9) en plus du premier registre (3) et de la règle de calcul, dans lequel, pendant la durée d'exécution, il est décidé automatiquement si la deuxième valeur de signal (4, 6, 7, 8, 9) est lue depuis le deuxième registre (5) ou si la deuxième valeur de signal (4, 6, 7, 8, 9) est déterminée à partir de la première valeur de signal (2) à l'aide de la règle de calcul.
